(19) Europäisches Patentamt
European Patent Office
Office européen des brevets

(11) **EP 2 849 208 A1**

(12) **DEMANDE DE BREVET EUROPEEN**

(43) Date de publication:
**18.03.2015 Bulletin 2015/12**

(51) Int Cl.:
***H01L 21/02*** *(2006.01)*

(21) Numéro de dépôt: **14184234.4**

(22) Date de dépôt: **10.09.2014**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **13.09.2013  FR 1358813**

(71) Demandeurs:
• **COMMISSARIAT A L'ENERGIE ATOMIQUE ET AUX ENERGIES ALTERNATIVES 75015 Paris (FR)**

• **Centre National de la Recherche Scientifique 75016 Paris (FR)**

(72) Inventeurs:
• **Baron, Thierry 38120 SAINT-EGREVE (FR)**
• **Bassani, Franck 38130 ECHIROLLES (FR)**

(74) Mandataire: **Esselin, Sophie et al Marks & Clerk France Conseils en Propriété Industrielle Immeuble Visium 22, Avenue Aristide Briand 94117 Arcueil Cedex (FR)**

(54) **Procede optimise de fabrication de motifs de materiau semiconducteur iii-v sur un substrat semiconducteur**

(57) L'invention a pour objet un procédé de fabrication de motifs de matériau semiconducteur III-V sur un substrat semiconducteur à base de silicium orienté (100) ou de germanium orienté (100) caractérisé en ce qu'il comprend les étapes suivantes :

- la réalisation d'un masque de croissance à la surface dudit substrat, définissant des motifs de masquage $Mi_{ox}$ de largeur L, de hauteur $h_{ox}$ avec une distance S entre motifs de masquage ;

- une étape de croissance de motifs $Mi_{III-V}$ de matériau III-V entre lesdits motifs de masquage, de manière à ce que lesdits motifs présentent une hauteur h par rapport au plan supérieur desdits motifs de masquage, ladite hauteur h étant supérieure ou égale à une hauteur minimale critique $h_c$, ladite étape de croissance comportant :

o la détermination de la vitesse de croissance $v_{100}$ selon une direction perpendiculaire à la face (100) dudit matériau III-V, et la détermination de la vitesse de croissance $v_{110}$ selon une direction perpendiculaire à la face (110) dudit matériau III-V, définissant un rapport $R = v_{100}/v_{110}$ ;

o la détermination de l'angle des dislocations θ dudit matériau III-V par rapport au plan dudit substrat (100) ;

o la détermination de ladite hauteur minimale critique $h_c$ définie par l'équation :

$$h_c = \frac{h_{ox} - S \times \tan(\theta)}{\frac{\tan(\theta)}{R} - 1}$$

o et R étant déterminé pour être supérieur à tan (θ).

FIG.2

**Description**

L'invention se situe dans le domaine de l'épitaxie de matériaux semiconducteurs III-V sur substrat de silicium et/ou de germanium pour des applications dans le domaine de la microélectronique, de la photonique, l'optoélectronique et du photovoltaïque.

Dans ces différents domaines, un enjeu primordial est de faire croitre des matériaux semiconducteurs III-V, pouvant être à base d'arsenic et/ou de phosphore, avec une très bonne qualité structurale (peu de défaut de type dislocations, macles, parois d'antiphases).

Ces matériaux revêtent un grand intérêt pour différentes applications telles que notamment : des transistors à effet de champ et haute mobilité, des émetteurs, détecteurs, modulateurs pour la photonique, des composants pour les dispositifs photovoltaïques ou bien encore des composants térahertz.

L'élaboration de matériaux semiconducteurs III-V sur substrat de Si a été étudiée depuis de nombreuses années et les difficultés liées à la croissance sont aujourd'hui clairement identifiées. En effet, elles sont dues à la différence de structure cristalline, à la forte différence de paramètres de maille et à la différence de coefficient de dilatation thermique entre la couche et le substrat, les couches III-V sur Si pouvant contenir de nombreux défauts structuraux tels que des parois d'antiphase, des dislocations étendues, voire des fissures.

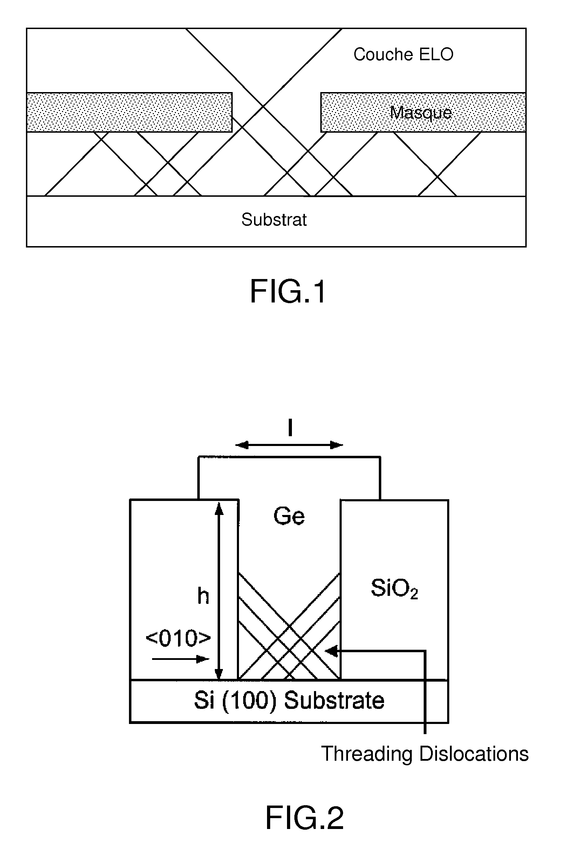

Deux solutions ou une combinaison de ces deux solutions ont notamment été proposées dans la littérature afin d'obtenir une couche de bonne qualité cristalline en surface dans le cas d'une couche à épitaxier présentant une forte différence de paramètre de maille avec son substrat. La première solution connue sous le nom de croissance épitaxiale latérale, comme décrit dans l'article de Zytkiewicz Z. « Epitaxial lateral overgrowth of semiconductors », In: Dhanaraj G, Byrappa K, Prasad V, Dudley M, editors, Handbook of crystal growth, Heidelberg: Springer Verlag: 2010, p.999-1039, (ELO pour epitaxial latéral overgrowth) dont le schéma est donné en figure 1, consiste à faire croitre, sur un substrat, une première couche qui présente une forte densité de dislocations puis à continuer la croissance au travers d'un masque, par épitaxie latérale, pour obtenir une couche supérieure.

La seconde solution comme représentée sur la figure 2, consiste à piéger les dislocations émergentes contre les parois latérales de motifs d'oxyde, d'après J.-S. Park, J. Bai, M. Curtin, B. Adekore, M. Carroll, A. Lochtefeld, Appl. Phys. Lett. 90, 052113 (2007) (Amberwave), si le rapport d'aspect de ces motifs est bien choisi. La croissance se fait par épitaxie sélective et les dislocations viennent alors se bloquer contre les murs d'oxyde.

Dans ce contexte, la présente invention a pour objet un procédé de fabrication comprenant la détermination de paramètres optimisés de manière à faire croître des matériaux III-V, avec des dislocations émergentes piégées et ainsi élaborer des couches de bonne qualité cristalline présentant une faible densité de dislocations.

Plus précisément, l'invention a pour objet un procédé de fabrication de motifs de matériau semiconducteur III-V sur un substrat semiconducteur à base de silicium orienté (100) ou de germanium orienté (100) caractérisé en ce qu'il comprend les étapes suivantes :

- la réalisation d'un masque de croissance à la surface dudit substrat, définissant des motifs de masquage $Mi_{ox}$ de largeur L, de hauteur $h_{ox}$ avec une distance S entre motifs de masquage ;
- une étape de croissance de motifs $Mi_{III-V}$ de matériau III-V entre lesdits motifs de masquage, de manière à ce que lesdits motifs présentent une hauteur h par rapport au plan supérieur desdits motifs de masquage, ladite hauteur h étant supérieure ou égale à une hauteur minimale critique $h_c$, ladite étape de croissance comportant :

  o la détermination de la vitesse de croissance $v_{100}$ selon une direction perpendiculaire à la face (100) dudit matériau III-V, et la détermination de la vitesse de croissance $v_{110}$ selon une direction perpendiculaire à la face (110) dudit matériau III-V, définissant un rapport $R = v_{100}/v_{110}$;
  o la détermination de l'angle des dislocations $\theta$ dudit matériau III-V par rapport au plan dudit substrat (100) ;
  o la détermination de ladite hauteur minimale critique $h_c$ définie par l'équation :

$$h_c = \frac{h_{ox} - S \times \tan(\theta)}{\dfrac{\tan(\theta)}{R} - 1}$$

  ■ et R étant déterminé pour être supérieur strictement à tan $(\theta)$.

Le matériau III-V peut typiquement être de l'arséniure de gallium GaAs ou de l'arséniure d'indium InAs.

Selon une variante de l'invention, le procédé comprend une étape de nucléation de matériau III-V entre lesdits motifs de masquage à la surface dudit substrat.

Selon une variante avantageuse de l'invention, le rapport R est supérieur à 5.

Selon une variante, les étapes de nucléation et de croissance des motifs sont réalisées dans des conditions similaires de température et de pression.

Selon une variante de l'invention, ladite hauteur h vérifie également la condition: $L > \dfrac{2}{R} \times h$, de manière à ce que lesdits motifs $Mi_{III-V}$ de matériau III-V ne coalescent pas.

Selon une variante de l'invention, les motifs de masquage et les motifs de matériau III-V sont des motifs linéaires.

Selon une variante de l'invention, le procédé comprend la réalisation de motifs supérieurs $Mj_{III-V}$ en matériau III-V, à la surface desdits motifs $Mi_{III-V}$ de matériau semiconducteur III-V.

Selon une variante de l'invention, le substrat étant en silicium, le matériau III-V est de l'arséniure de gallium.

Selon une variante de l'invention, l'angle des dislocations est de 54,7°.

Selon une variante de l'invention, le masque de croissance est réalisé par oxydation dudit substrat puis gravure.

Selon une variante de l'invention, le masque de croissance est obtenu par la réalisation d'une couche de matériau présentant une sélectivité à la gravure par rapport au silicium ou au germanium, suivie d'une opération de gravure locale de ladite couche.

Selon une variante de l'invention, la couche de matériau présentant une sélectivité à la gravure par rapport au silicium ou au germanium est en nitrure de silicium.

Selon une variante de l'invention, la distance entre motifs de masquage peut être comprise entre environ quelques dizaines de nanomètres et quelques centaines de nanomètres.

Selon une variante de l'invention, la largeur des motifs de masquage est supérieure à plusieurs dizaines de nanomètres.

Selon une variante de l'invention, l'étape de nucléation entre lesdits motifs de masquage, permettant la croissance dudit matériau III-V étant réalisée à une température dite de nucléation, l'étape de croissance des motifs $Mi_{III-V}$ étant effectuée à une température dite de croissance, ladite température de croissance est supérieure à ladite température de nucléation.

Selon une variante de l'invention, ladite température de nucléation est comprise entre environ 300 °C et 450 °C, ladite température de croissance étant comprise entre environ 350 °C et 650 °C.

Selon une variante de l'invention, le procédé comprend en outre une étape d'épitaxie sélective de matériau Si ou Ge en fond de cavité réalisée après l'opération de réalisation des motifs de masquage et avant l'opération de croissance des motifs $Mi_{III-V}$, permettant d'améliorer les propriétés physiques des matériaux III-V.

L'invention sera mieux comprise et d'autres avantages apparaîtront à la lecture de la description qui va suivre donnée à titre non limitatif et grâce aux figures annexées parmi lesquelles :

- la figure 1 illustre un premier exemple de procédé de croissance de matériau III-V sur substrat de silicium (100) selon l'art connu ;
- la figure 2 illustre un second exemple de procédé de croissance de matériau III-V sur substrat de silicium (100) selon l'art connu ;
- la figure 3 illustre les paramètres exploités dans la présente invention pour déterminer une géométrie de motifs optimale en termes de qualité structurale de matériau III-V, à la surface d'un substrat (100) ;

- la figure 4 illustre différentes hauteurs de croissance critiques calculées pour le procédé de la présente invention en fonction de la distance entre motifs de masquage et permettant de piéger l'ensemble des dislocations émergentes, et ce pour différents rapports de vitesse $v_{100}/ v_{110}$ et pour différentes hauteurs de motifs de masquage ;
- la figure 5 illustre une image prise par microscopie électronique à balayage STEM, de motifs $Mi_{III-V}$ linéaires, obtenus avec le procédé de l'invention et prise en coupe transverse selon la direction (110) parallèle auxdits motifs linéaires et illustrant le piégeage d'une dislocation émergente dans lesdits motifs de matériau III-V ;
- les figures 6a à 6e illustrent les différentes étapes technologiques d'un exemple de procédé selon l'invention.

Pour réaliser des motifs linéaires ou de toute autre géométrie, en matériau III-V à la surface d'un substrat en silicium ou en germanium, le procédé de la présente invention comprend la réalisation d'un masque de croissance à la surface du substrat d'intérêt en silicium (100) ou en germanium (100).

Le masque de croissance est réalisé en matériau présentant une sélectivité à la gravure par rapport au matériau du substrat.

Typiquement, le masque de croissance peut être en $SiO_2$ ou en SiN.

De manière générale, le procédé de la présente invention permet de piéger les dislocations, près du substrat de croissance et permet le développement de couches de matériau III-V, présentant très peu de dislocations et donc une très bonne qualité structurale, pouvant par la même servir également de support pour réaliser des fonctions supplémentaires photoniques, optoélectroniques ou bien encore photovoltaïques.

Pour cela, le procédé comprend une étape de détermination de certains paramètres, afin d'optimiser l'étape de croissance du matériau III-V, consécutive à une opération préalable de nucléation.

Plus précisément, il convient de déterminer préalablement les paramètres suivants :

- la vitesse de croissance $v_{100}$ de la face (100) dudit matériau III-V ;
- la vitesse de croissance $v_{110}$ de la face (110) dudit matériau III-V.

Ces vitesses peuvent par exemple être déterminées au préalable par croissance sur des substrats orientés (100) et (110).

On définit ainsi un ratio : $R = v_{100}/v_{110}$ et avec $R > 1$, voir $R >> 1$. Les vitesses peuvent notamment être calculées en :

- déterminant l'épaisseur de matériau déposé, par ellipsométrie ou par microscopie électronique à balayage MEB (ou TEM) en coupe ;
- et divisant l'épaisseur déterminée par le temps de dépôt.

De manière générale, l'angle des dislocations θ dudit matériau III-V par rapport au plan (100) dudit substrat, peut être par exemple déterminé par microscopie électronique en transmission.

L'utilisation de ce type de méthode est notamment décrite dans la publication des auteurs : T.A, C.W. Leitz, M.T. Curie, E.A. Fitzgerald, A. Lochtefeld et al « High quality Ge on Si by epitaxial necking » Applied Physics Letters, Volume 76, Number 25, 19 june 2000.

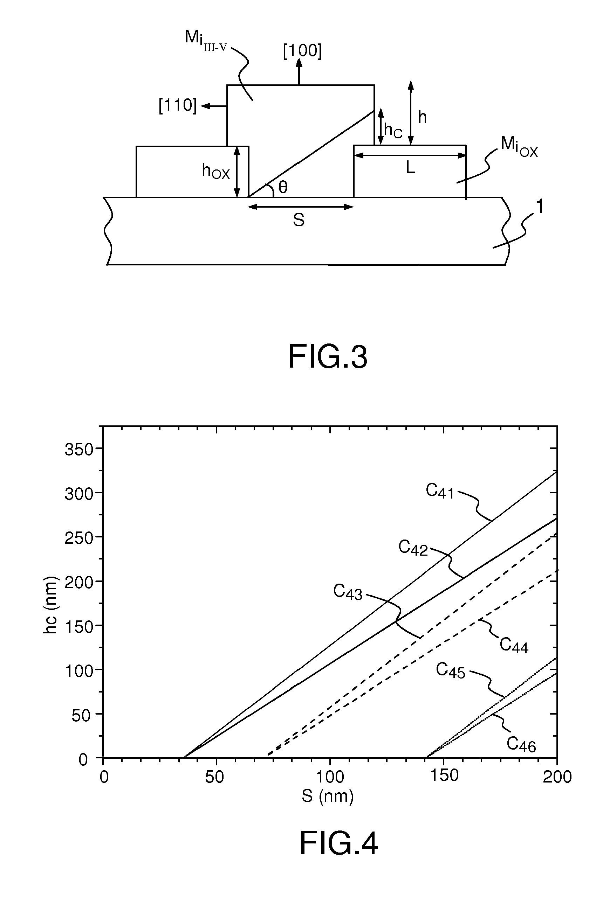

Comme illustré en figure 3, sur un substrat 1, on réalise des motifs de masquage de croissance $Mi_{ox}$ de largeur L et de hauteur hox, séparés d'une distance S au niveau du substrat. On est alors en mesure de réaliser après une phase classique (non représentée) de nucléation riche en dislocations (phase néanmoins optionnelle selon les matériaux III-V concernés) et de faible épaisseur (typiquement quelques dizaines de nanomètres), la croissance sélective du matériau III-V entre lesdits motifs $Mi_{ox}$.

On est ainsi en mesure de déterminer une hauteur critique de croissance des motifs en matériau III-V, permettant de piéger les dislocations entre les motifs de masquage. Cette figure schématise la présence d'une dislocation dans le matériau III-V, ladite dislocation faisant un angle θ avec le substrat (100), dans les motifs $Mi_{III-V}$ de matériau III-V, ainsi définis par croissance.

La hauteur minimale critique, qu'il conviendra de dépasser pour piéger le maximum de dislocations est définie par l'équation ci-après :

$$h_c = \frac{h_{ox} - S \times \tan(\theta)}{\frac{\tan(\theta)}{R} - 1} \qquad (1)$$

avec S : la distance entre deux motifs de masquage, adjacents et $R > \tan(\theta)$.

D'autre part, recherchant à définir des motifs unitaires $Mi_{III-V}$ de matériau III-V, il est important de respecter une distance minimale entre lesdits motifs $Mi_{III-V}$ de matériau III-V de manière à ce qu'ils ne puissent coalescer entre eux.

Pour cela, on peut avantageusement également imposer que la largeur des motifs et la hauteur des motifs lors de leur croissance, soient en corrélation avec le rapport entre lesdites vitesses de croissance.

Soit, le second critère ci-dessous :

$$L > \frac{2}{R} \times h$$

Typiquement, on impose des conditions de croissance telles que les motifs unitaires restent séparés par des motifs de masquage de largeur L telle que l'on conserve une distance d'au moins quelques dizaines de nanomètres.

Dans le cas d'une croissance de GaAs sur silicium (100), l'angle θ est égal à 54,7° par rapport au plan (100), par conséquent si le rapport $h_{ox}/S$ de la cavité est inférieur à tan(54,7°), soit environ 1.41, quelques dislocations peuvent alors se propager au dessus du motif de gravure et peuvent ainsi être bloquées par les murs du mésa de croissance, lesdits mésas correspondant aux motifs $Mi_{III-V}$.

Selon le procédé de la présente invention, on cherche à se placer dans des conditions de croissance telle que la vitesse de croissance de la face (100) est bien supérieure à celle de la face (110), c'est-à-dire R»1, en tout état de cause R > tan(54.7°).

On pourra ainsi déterminer des conditions de croissance avec lesquelles on obtient par exemple un rapport R égal à environ 5.

L'équation (1) montre que dans le cas présent, $h_c$ est une fonction linéaire de S avec une pente égale à -tan(54.7°)/[(tan(54.7°)/R)-1] (pente positive car R>tan(54.7°)), l'abscisse à l'origine étant $h_{ox}$/ [(tan(54.7°)/R)-1] .

La figure 4 reporte l'épaisseur minimale $h_c$ en fonction de la largeur de cavité S obtenue à partir de l'équation (1) pour des rapports de vitesse R de 5 et 10 et pour trois hauteurs de cavité hox égale à 50nm ou 100 nm ou 200 nm. On obtient ainsi les courbes suivantes :

$C_{41}$ avec R = 5 et hox = 50nm ;
$C_{42}$ avec R = 10 et hox = 50 nm ;
$C_{43}$ avec R = 5 et hox = 100 nm ;
$C_{44}$, avec R = 10 et hox = 100 nm ;
$C_{45}$ avec R = 5 et hox = 200 nm ;
$C_{46}$ avec R = 10 et hox = 200 nm.

A partir de la détermination de cette épaisseur critique, on peut ainsi réaliser une opération de croissance permettant de définir des motifs de hauteur h supérieure à cette hauteur critique et permettant de plus d'éviter la coalescence des mésas de croissance pour laquelle la condition suivante est ainsi avantageusement satisfaite où L désigne l'espacement entre cavité :

$$L > \frac{2}{R} \times h \qquad (2)$$

Typiquement, on impose des conditions de croissance telles que les motifs unitaires restent séparés d'une distance d'au moins quelques dizaines de nanomètres.

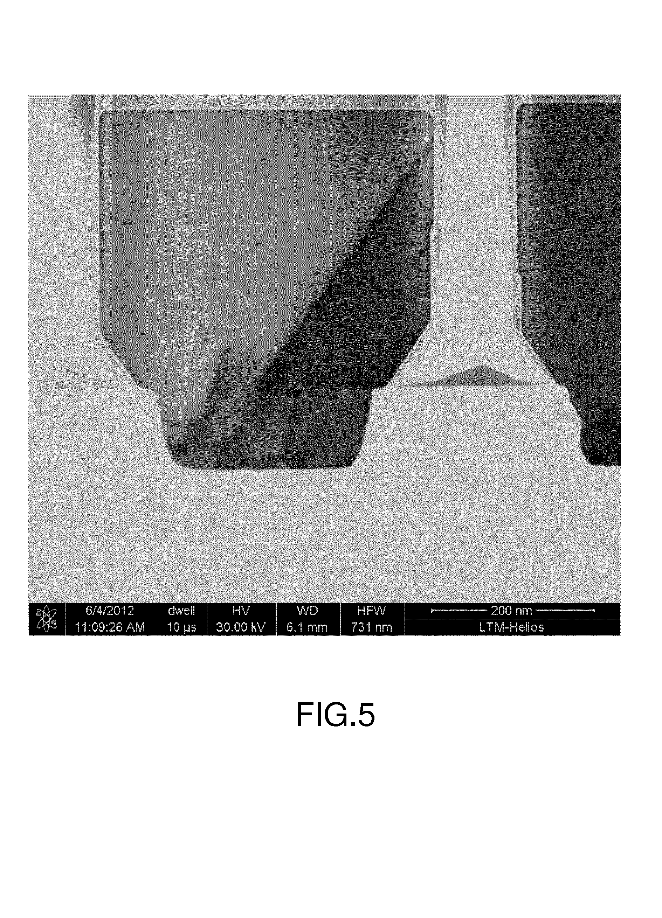

La figure 5 illustre l'image STEM prise en coupe transverse selon la direction (110) parallèle auxdits motifs linéaires et illustrant le piégeage d'une dislocation émergente dans le mur de la mésa de matériau III-V pour laquelle R~5, hox~90 nm, S~270 nm, L~240 nm et h~350 nm.

Ainsi avantageusement, mais non de manière limitative, les conditions suivantes permettent d'obtenir des motifs de matériau III-V qui n'ont pas coalescé et dont les dislocations sont piégées au niveau des motifs de masquage :

$$R \gg 1.5 \; ;$$

$$h \; > \; h_c = \frac{h_{ox} - S \times \tan(\theta)}{\frac{\tan(\theta)}{R} - 1}$$

$$L > \frac{2}{R} \times h$$

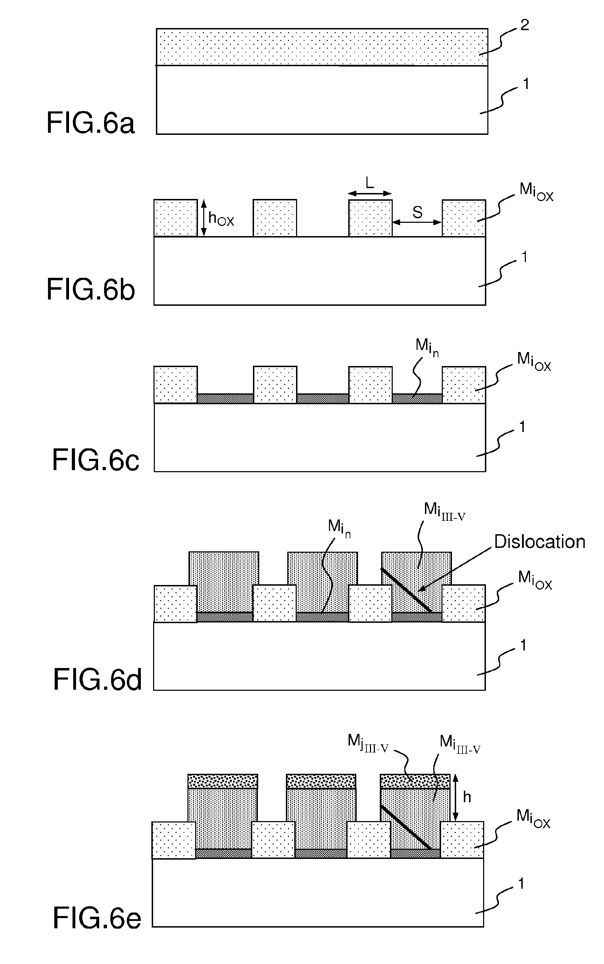

Un exemple de réalisation de motifs selon l'invention est décrit ci-après avoir défini les paramètres de croissance, et les principales étapes sont illustrées à l'aide des figures 6a à 6e.

Etape 1 :

A partir d'un substrat de silicium (100), on procède à une opération d'oxydation thermique dudit substrat 1, permettant de définir une couche supérieure d'oxyde de silicium 2, comme illustré en figure 6a.

Etape 2 :

A partir de cette couche d'oxyde, des cavités sont définies par lithographie et gravure dans la couche de $SiO_2$ pour découvrir la surface de silicium, comme illustré en figure 6b. Ces cavités présentent des largeurs de lignes S, séparées par des largeurs L de motifs de masquage $Mi_{ox}$ de $SiO_2$, lesdits motifs de masquage présentant des hauteurs $h_{ox}$.

Cette surface est ensuite préparée de façon classique (attaque HF par exemple) pour éliminer le $SiO_2$ restant au fond du trou ou pour enlever le $SiO_2$ natif.

Etape 3 :

Pour réaliser la croissance de matériaux III-V, par exemple Ga-As, sélectivement dans les cavités de $SiO_2$, on procède à plusieurs opérations de croissance épitaxiale.

Une première étape de nucléation a lieu à basse température (350°C-450°C) qui peut varier selon les différentesmachines car la mesure de température se fait soit par pyrométrie soit par un thermocouple placé en contact avec la face arrière du substrat. Le rapport V/III varie classiquement de 1 à 50 selon les machines et méthodes de croissance utilisées pouvant être l'épitaxie par jet moléculaire encore couramment désignée par l'acronyme MBE pour « Molecular Beam Epitaxy » ou l'épitaxie en phase vapeur aux organomôtalliques (EPVOM, aussi connue sous l'acronyme anglophone MOCVD : Metalorganic Vapour Phase Déposition). On définit une couche restant dans la cavité entre les motifs de masquage de $SiO_2$, comme illustré en figure 6c. Cette couche de nucléation contenant de nombreux défauts structuraux permet de définir une base de motifs $Mi_n$ liés, au fort désaccord de paramètre de maille, défauts qui vont être bloqués par la cavité lors de la croissance des couches successives, permettant de définir les motifs $Mi_{III-V}$.

Etape 4 :

Une deuxième couche de matériau III-V est déposée à plus haute température, typiquement entre 550°C et 650°C avecun ratio III-V compris entre 1 et 50. La pression totale est adaptée en fonction de la géométrie du réacteur, mais des valeurs typiques sont comprises entre 1 et 100 Torr. Cette couche sort de la cavité avec une face supérieure orientée (100) et des faces latérales orientées (110), avec des faces (100) stabilisées, comme illustré en figure 6d. La face externe du matériau III-V étant en As, on impose ainsi au niveau des vitesses de croissance (100) As > (110)As. En effet, il est nécessaire de respecter la condition suivante : V110 < V100 < V avec V la vitesse de croissance de toutes les autres directions de facettes existantes.

Etape 5 :

Le réseau de motifs linéaires $Mi_{III-V}$ exempt de défauts structuraux en surface peut à son tour servir de substrat virtuel pour la croissance de multicouches plus complexes et donc de motifs supérieurs $Mj_{III-V}$.

Les dimensions typiques des cavités sont ajustées en fonction des besoins liés aux applications.

A titre d'exemple, le rapport L/h peut être inférieur ou égal à 1 et le paramètre S peut varier de 20 nm à plusieurs centaines de nanomètres.

## Revendications

1. Procédé de fabrication de motifs de matériau semiconducteur III-V sur un substrat semiconducteur à base de silicium orienté (100) ou de germanium orienté (100) **caractérisé en ce qu'**il comprend les étapes suivantes :

   - la réalisation d'un masque de croissance à la surface dudit substrat, définissant des motifs de masquage $Mi_{ox}$ de largeur L, de hauteur $h_{ox}$ avec une distance S entre motifs de masquage ;
   - une étape de croissance de motifs $Mi_{III-V}$ de matériau III-V entre lesdits motifs de masquage, de manière à ce que lesdits motifs présentent une hauteur h par rapport au plan supérieur desdits motifs de masquage, ladite hauteur h étant supérieure ou égale à une hauteur minimale critique $h_c$, ladite étape de croissance comportant :

   o la détermination de la vitesse de croissance $v_{100}$ selon une direction perpendiculaire à la face (100) dudit matériau III-V, et la détermination de la vitesse de croissance $v_{110}$ selon une direction perpendiculaire à la face (110) dudit matériau III-V, définissant un rapport $R = V_{100}/ v_{110}$ ;
   o la détermination de l'angle des dislocations $\theta$ dudit matériau III-V par rapport au plan dudit substrat (100) ;
   o la détermination de ladite hauteur minimale critique $h_c$ définie par l'équation :

   $$h_c = \frac{h_{ox} - S \times \tan(\theta)}{\frac{\tan(\theta)}{R} - 1}$$

   et R étant déterminé pour être supérieur strictement à tan ($\theta$).

2. Procédé de fabrication de motifs de matériau semiconducteur III-V sur un substrat semiconducteur à base de silicium orienté (100) ou de germanium orienté (100) selon la revendication 1, **caractérisé en ce qu'**il comprend une étape de nucléation de matériau III-V entre lesdits motifs de masquage à la surface dudit substrat.

3. Procédé de fabrication de motifs de matériau semiconducteur III-V sur un substrat semiconducteur à base de silicium (100) ou de germanium (100) selon l'une des revendications 1 ou 2, **caractérisé en ce que** ladite hauteur h vérifie également la condition :

   $$L > \frac{2}{R} \times h$$, de manière à ce que lesdits motifs

$Mi_{III-V}$ de matériau III-V ne coalescent pas.

4. Procédé de fabrication de motifs de matériau semiconducteur III-V sur un substrat semiconducteur à base de silicium (100) ou de germanium (100) selon l'une des revendications 1 à 3, **caractérisé en ce que** le rapport R est supérieur à 5.

5. Procédé de fabrication de motifs de matériau semiconducteur III-V sur un substrat semiconducteur à base de silicium (100) ou de germanium (100) selon l'une des revendications 2 à 4, **caractérisé en ce que** les étapes de nucléation et de croissance des motifs sont réalisées dans des conditions similaires de température et de pression.

6. Procédé de fabrication de motifs de matériau semiconducteur III-V sur un substrat semiconducteur à base de silicium (100) ou de germanium (100) selon l'une des revendications 2 à 5, caractérisé en ce l'étape de nucléation étant réalisée à une température dite de nucléation, l'étape de croissance des motifs $Mi_{III-V}$ étant réalisée à une température dite de croissance, ladite température de croissance est supérieure à ladite température de nucléation.

7. Procédé de fabrication de motifs de matériau semiconducteur III-V sur un substrat semiconducteur à base de silicium (100) ou de germanium (100) selon la revendication 6, **caractérisé en ce que** ladite température de nucléation est comprise entre environ 300°C et 450°C, ladite température de croissance étant comprise entre environ 350°C et 650°C.

8. Procédé de fabrication de motifs de matériau semiconducteur III-V sur un substrat semiconducteur à base de silicium (100) ou de germanium (100) selon l'une des revendications 1 à 7, **caractérisé en ce que** les motifs de masquage et les motifs de matériau III-V sont des motifs linéaires.

9. Procédé de fabrication de motifs de matériau semiconducteur III-V sur un substrat semiconducteur à base de silicium (100) ou de germanium (100) selon l'une des revendications 1 à 8, **caractérisé en ce qu'**il comprend la réalisation de motifs supérieurs $Mj_{III-V}$ à la surface desdits motifs de matériau semiconducteur III-V.

10. Procédé de fabrication de motifs de matériau semiconducteur III-V sur un substrat semiconducteur à base de silicium (100) ou de germanium (100) selon l'une des revendications 1 à 9, **caractérisé en ce que** le substrat étant en silicium, le matériau III-V est de l'arséniure de gallium.

11. Procédé de fabrication de motifs de matériau semiconducteur III-V sur un substrat semiconducteur à base de silicium (100) ou de germanium (100) selon la revendication 10, **caractérisé en ce que** l'angle des dislocations est de 54,7°.

**12.** Procédé de fabrication de motifs de matériau semiconducteur III-V sur un substrat semiconducteur à base de silicium (100) ou de germanium (100) selon l'une des revendications 1 à 11, **caractérisé en ce que** le masque de croissance est réalisé par oxydation dudit substrat puis gravure.

**13.** Procédé de fabrication de motifs de matériau semiconducteur III-V sur un substrat semiconducteur à base de silicium (100) ou de germanium (100) selon l'une des revendications 1 à 11, **caractérisé en ce que** le masque de croissance est réalisé par la réalisation d'une couche de matériau présentant une sélectivité à la gravure par rapport au silicium ou au germanium, suivie d'une opération de gravure locale de ladite couche.

**14.** Procédé de fabrication de motifs de matériau semiconducteur III-V sur un substrat semiconducteur à base de silicium (100) ou de germanium (100) selon la revendication 13, **caractérisé en ce que** la couche de matériau présentant une sélectivité à la gravure par rapport au silicium ou au germanium est en nitrure de silicium.

**15.** Procédé de fabrication de motifs de matériau semiconducteur III-V sur un substrat semiconducteur à base de silicium (100) ou de germanium (100) selon l'une des revendications 1 à 14, **caractérisé en ce que** la distance entre motifs de masquage peut être comprise entre environ quelques dizaines de nanomètres et quelques centaines de nanomètres.

**16.** Procédé de fabrication de motifs de matériau semiconducteur III-V sur un substrat semiconducteur à base de silicium (100) ou de germanium (100) selon l'une des revendications 1 à 15, **caractérisé en ce que** la largeur des motifs de masquage est supérieure à plusieurs dizaines de nanomètres.

**17.** Procédé de fabrication de motifs de matériau semiconducteur III-V sur un substrat semiconducteur à base de silicium (100) ou de germanium (100) selon l'une des revendications 1 à 16, **caractérisé en ce qu'**il comprend en outre une étape d'épitaxie sélective de matériau Si ou Ge en fond de cavité réalisée après l'opération de réalisation des motifs de masquage et avant l'opération de croissance des motifs Mi$_{III-V}$.

Couche ELO

Masque

Substrat

# FIG.1

$l$

Ge

$h$

$<010>$

SiO$_2$

Si (100) Substrate

Threading Dislocations

# FIG.2

FIG.3

FIG.4

6/4/2012 | dwell | HV | WD | HFW | 200 nm
11:09:26 AM | 10 µs | 30.00 kV | 6.1 mm | 731 nm | LTM-Helios

FIG.5

FIG.6a

FIG.6b

FIG.6c

FIG.6d

FIG.6e

Europäisches
Patentamt

European
Patent Office

Office européen
des brevets

**RAPPORT DE RECHERCHE EUROPEENNE**

Numéro de la demande

EP 14 18 4234

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2008/030574 A1 (AMBERWAVE SYSTEMS CORP [US]; BAI JIE [US]; PARK JI-SOO [US]; LOCHTEFEL) 13 mars 2008 (2008-03-13) * alinéa [0010] - alinéa [0057] * * figures 1-7 * ----- | 1-17 | INV. H01L21/02 |
| A | WO 2008/051503 A2 (AMBERWAVE SYSTEMS CORP [US]; LI JIZHONG [US]; LOCHTEFELD ANTHONY J [US]) 2 mai 2008 (2008-05-02) * alinéa [0024] - alinéa [0035] * * figure 1 * ----- | 1-17 | |
| A | US 2011/049568 A1 (LOCHTEFELD ANTHONY J [US] ET AL) 3 mars 2011 (2011-03-03) * alinéa [0047] - alinéa [0097] * * figures 3-6 * ----- | 1-17 | |

DOMAINES TECHNIQUES RECHERCHES (IPC)

H01L

Le présent rapport a été établi pour toutes les revendications

| Lieu de la recherche | Date d'achèvement de la recherche | Examinateur |
|---|---|---|
| Munich | 7 janvier 2015 | Bruckmayer, Manfred |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.................................................................................................
& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**   EP 14 18 4234

La présente annexe indique les membres de la famille de brevets relatifs aux documents brevets cités dans le rapport de
recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

07-01-2015

| Document brevet cité au rapport de recherche | Date de publication | Membre(s) de la famille de brevet(s) | Date de publication |
|---|---|---|---|
| WO 2008030574 A1 | 13-03-2008 | EP 2062290 A1 | 27-05-2009 |
| | | US 2008099785 A1 | 01-05-2008 |
| | | US 2012199876 A1 | 09-08-2012 |
| | | US 2014342536 A1 | 20-11-2014 |
| | | WO 2008030574 A1 | 13-03-2008 |
| WO 2008051503 A2 | 02-05-2008 | US 2008093622 A1 | 24-04-2008 |
| | | US 2008187018 A1 | 07-08-2008 |
| | | US 2013252361 A1 | 26-09-2013 |
| | | WO 2008051503 A2 | 02-05-2008 |
| US 2011049568 A1 | 03-03-2011 | US 2011049568 A1 | 03-03-2011 |
| | | US 2013105860 A1 | 02-05-2013 |
| | | US 2013285116 A1 | 31-10-2013 |
| | | US 2014106546 A1 | 17-04-2014 |
| | | US 2014374798 A1 | 25-12-2014 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **J.-S. PARK ; J. BAI ; M. CURTIN ; B. ADEKORE ; M. CARROLL ; A. LOCHTEFELD.** *Appl. Phys. Lett.,* 2007, vol. 90, 052113

- **T.A, C.W. LEITZ ; M.T. CURIE ; E.A. FITZGERALD ; A. et al.** High quality Ge on Si by epitaxial necking. *Applied Physics Letters,* 19 Juin 2000, vol. 76 (25